# EUROPÄISCHE PATENTANMELDUNG

(11) **EP 2 197 000 A1**
(43) Veröffentlichungstag der Anmeldung: **16.06.2010**
(21) Anmeldenummer: 09178212.8
(22) Anmeldetag: 07.12.2009
(51) Int. Cl.: H01C 1/014, H01C 7/12, H05K 1/18

(54) **Vorrichtung zur Anordnung elektronischer Bauelemente**

(30) Priorität: 05.12.2008 DE 202008016137 U
(71) Anmelder: Aizo AG, 35578 Wetzlar (DE)
(72) Erfinder: Beck, Wilfried, 65191, Wiesbaden (DE); Burk, Michael, 35764, Sinn (DE); Hemmler, Wolfgang, 35578, Wetzlar (DE)
(74) Vertreter: Englaender, Klaus

(57) **Zusammenfassung**

Vorrichtung zur Anordnung elektronischer Halbleiterbauelemente 4 auf elektronischen Leiterplatten, umfassend eine e elektronische Leiterplatte, ein elektronisches Halbleiterbauelement 4, Positionierelemente 1, welche das elektronische Halbleitcrbaudement 4 zur Ersparnis von Bauraum im wesentlichen parallel zur elektronischen Leiterplatte und von dieser beabstandet anordnen und mit dieser elektrisch verbinden.

## Beschreibung

Die Erfindung betrifft eine Vorrichtung zur Anordnung elektronischer Bauelemente auf Leiterplatten.

In der Haibleitertechnik besteht das Bedürfnis, elektronische Bauelemente auf immer engerem Raum auf Leiterplatten anzubringen.

Es ist daher Aufgabe der vorliegenden Erfindung eine Möglichkeit bereitzustellen noch mehr elektronische Bauelemente auf dem selben Bauraum anordnen zu können.

Diese Aufgabe wird durch die Merkmale der unabhängigen Ansprüche gelöst; vorteilhafte Ausgestaltungen ergeben sich aus den Unteransprüchen.

Insbesondere wird die Aufgabe gelöst durch eine
Vorrichtung zur Anordnung elektronischer Bauelemente, insbesondere elektronischer Halbleiterbauelemente auf elektronischen Leiterplatten, umfassend eine elektronische Leiterplatte, ein elektronisches Bauelement, insbesondere ein elektronisches Halbleiterbauelement und in besonderem Maße Varistoren, Positionierelemente, welche das elektronische Bauelement/Halbleiterbauelement/Varistor im Wesentlichen parallel
zur elektronischen Leiterplatte und von dieser beabstandet anordnen.

Hierbei kann die elektronische Leiterplatte jede dem Fachmann bekannte Gestalt aufwiesen und aus jedem Material bestehen. Insbesondere kann es sich um elektronische Leiterplatten handeln, welche bereits einen starken Miniaturisierungsgrad aufweisen, weil sie auf engem Raum, wie z.B. in Energiesparlampen o.a. verbaut werden.

Bei den elektronischen Bauelementen kann es sich ebenfalls um jedes dem Fachmann bekanntes Bauelement handeln. Besonders bevorzugt sind jedoch komplexere elektronische Bauelemente, wie beispielsweise Halbleiter und/oder Varistoren. Im Weiteren wird die Erfindung daher insbesondere beispielhaft an einem Varistor dargestellt, ohne sie aber hierdurch aber auf einen Varistor einschränken zu wollen.

Die erfindungsgemäße Vorrichtung zur Anordnung elektronischer Bauelemente auf Leiterplatten welche das Bauelement im Wesentlichen parallel zur elektronischen Leiterplatte und von dieser beabstandet anordnet bewirkt, daß mehrere dieser Bauelemente, insbesondere Halbleiterbauelemente bzw. Varistoren Übereinander angeordnet werden können (Stapelung). Eine derartig Stapelung hat den Vorteil, daß mit zunehmender Bauhöhe die benötigte Leiterplattenfläche reduziert werden kann.

Die vorliegende Erfindung grenzt sich von übereinander angeordneten Leiterplatten dadurch ab, daß die vorliegende Erfindung einstückig ist und sowohl das Bauelement aufnimmt, als auch auf der ursprünglichen Leiterplatte befestigt wird, Übereinander angeordnete Leiterplatten benötigen hingegen ein zusätzliches Bauteil (Abstandhalter) auf welchem sie angebracht werden und mit dessen Hilfe sie auf der ersten Leiterplatte angeordnet werden. In Abgrenzung hierzu ist die Erfindung hingegen einteilig.

Bei Verwendung von mindestens zwei übereinander liegenden Leiterplatten geht darüber hinaus hingegen Bauraum verloren, nämlich derjenige, den die zweite Leiterplatte einnimmt. Auch dies ist bei der erfindungsgemäßen Ausführungsform nicht der Fall.

Darüber hinaus müssen die Leiterplatten, wiederum selbst mit Leitern verbunden werden, was bei der vorliegenden Erfindung nicht der Fall ist; ein weiterer separater Leiter fällt somit weg.

Vorliegende erfindungsgemäße Bauelemente sind im Gegensatz zu Leiterplatten die wiederum selbst auf Leiterplatten angeordnet werden, insbesondere maschinenbestückbar. Da die erfindungsgemäß beschriebenen Bauelemente definierte Greifbereiche ausweisen und da sie definierte Anschlüsse ausweisen, können sie mit Hilfe von Maschinen präziser auf Leiterplatten angeordnet werden, als gleichartige, nicht erfindungsgemäß ausgestaltete Bauelemente. Gleichartige, nicht erfindungsgemäß ausgestaltete Bauelemente weisen insbesondere dünne Anschlußbeine auf, welche bei Anlieferung meist verbogen sind, was zur Folge hat, daß sie ohne Nacharbeit nicht mehr in vordefinierte Anschlüsse passen.

"Im Wesentlichen parallel" bedeutet im vorliegenden Fall, daß im Rahmen einer Maschinenbestückung eine Parallelität der größten Fläche des Bauelements zur Leiterplatte von wenigen Grad Abweichung erzielbar ist, insbesondere von unter 5 Grad Abweichung und sogar von unter einem Grad Abweichung.

Eine vorteilhafte Ausgestaltung der Erfindung, wobei durch die Positionierelemente der Körper des elektronischen Bauelements von der Leiterplatte beabstandet angeordnet wird, und die elektronischen Anschlüsse des Bauelements mit Hilfe der Positionierelemente elektrisch leitend mit der Leiterplatte verbunden werden, bewirkt, daß das gesamte Bauelement auf der erfindungsgemäßen Anordnung nicht nur physisch angebracht wird, sondern auch auf dieser Anordnung außerdem elektrisch leitend angebracht wird, sodaß dieses Bauelement sowohl von der erfindungsgemäßen Anordnung aus mit Energie versorgt werden kann, als auch fakultativ durch seine eigenen Anschlüsse. Besonders bevorzugt st jedoch, daß die Positionierelemente die elektrische Versorgung des Bauelements / Vanstrors exklusiv übernehmen.

Dies hat den Vorteil, daß ein jeder dieser Anschlüsse kleiner ausgestaltet werden kann und hat den weiteren Vorteil, daß wenn ein Anschluß beispielsweise aufgrund mechanischer Überlastung ausfällt, nicht die gesamte Leiterplatte unbrauchbar wird.

Eine vorteilhafte Ausgestaltung der Erfindung, wobei eines der Positionierelemente mindestens die äußere Kontur einer der der Kontaktflächen des Halbleiterbauelements im Wesentlichen nachvollzieht oder wobei mehr als eines der Positionierelemente mindestens die äußere Kontur von mehr als einer der Kontaktflächen des Halbleiterbauelements im Wesentlichen nachvollzieht hat den Vorteil besonderer Stabilität, da die Stabilisierung der äußeren Kontur in besonderer Weise vor Winkelabweichungen beim und nach dem Verbauen schützt.
Hierbei wird unter "...äußere Kontur..." der äußere, insbesondere der leiterplattenparallele äußere Rand des Bauelements verstanden.
Unter "Nachvollziehen des wesentlichen Teils der äußeren Kontur" wird verstanden, daß nicht die gesamte äußere Kontur nachvollzogen werden muß, aber mindestens so viel, daß eine stabile Gesamtanordnung, als eine verkippungssteife Gesamtanordnung erzielt wird. Eine verkippungssteife Gesamtanordnung wird insbesondere dann erzielt, wenn mehr als 50% dieser äußeren Kontur nachvollzogen werden. Hierbei bedeutet "nachvollzogen", daß ihrer Gestalt im Wesentlichen gefolgt wird, daß also im Falle eines z.B. kreisrunden Varistors dieser Kreisgestalt zu mehr als 50% gefolgt wird. Hierbei bedeutet "gefolgt uerd", daß die Kontur des Positionierelements nicht deckungsgleich auf der Kontur des Bauelements liegen muß, sondern auch eine auch eine in Richtung des Zentrums verschobene parallele Gestalt haben kann, wobei jedoch die Gestalt selbst im wesentlichen nachvollzogen wird, aber nur eben ein wenig versetzt, Dies kann beispielsweise sinnvoll sein, wenn beispielsweise Trägermaterial eingespart werden soll.

Eine weitere vorteilhafte Ausgestaltung der Erfindung, wobei das elektronische Bauelement, insbesondere der Varistor, ausschließlich mit den Positionierelement verbunden wird und das Positionierelement mit Hilfe von mehr als zwei Verbindungen ausschließlich mit der Leiterplatte verbunden wird, bewirkt, daß das gesamte Bauelement, insbesondere der Varistor, auf der erfindungsgemäßen Anordnung nicht nur physisch angebracht wird, sondern auf dieser Anordnung außerdem auch elektrisch leitend angebracht wird, sodaß dieses Bauelement ausschließlich von der erfindungsgemäßen Anordnung aus mit Energie versorgt wird. Das Positionierelement umfaßt somit selbst erfindungsgemäß stromleitendes Material, sodaß das Bauelement, insbesondere der Varistor, an diesem elektrisch leitend anschließbar ist und mit diesem stromieitenden Material eine elektrische Verbindung mit der Leiterplatte herstellbar ist. Dies hat den Vorteil, daß vormontierte Baugruppen, bestehend aus elektronischem Bauelement, und insbesondere aus einem Varistor, und Anordnungen davon vorgefertigt werden können und gemeinsam in einem einzigen Arbeitsschritt auf der elektronische Leiterplatte angeordnet und mit dieser insbesondere durch Verlötung oder leitender Verklebung verbunden werden können.

Wenn die Verbindung des Positionierelements mit der Leiterplatte mit Hilfe einer am Positionierelement befindlichen leiterplattenparallelen Abschnitts erfolgt (z.B. ein Anschluß mit einem Anschlußende in Fußgestalt), so kann das erfindungsgemäße Positionierelement auch auf einer einzigen, nämlich der dem Bauelement zugewandten Seite, einer zweiseitig mit Leiterbahnen bestückten Leiterplatte befestigt werden, wodurch die der Befestigung gegenüber liegende Seite parallel zur Befestigungsstelle mit weiteren Leiterbahnen bestückbar ist.

Eine weitere vorteilhafte Ausgestaltung der Erfindung, wobei das Positionierelement aus mindestens zwei Teilelementen besteht, nämlich mindestens einem Trägerteilelement (unter dem Bauelement angeordnet) umfasst und mindestens ein Halteteilelement (über dem Bauelement angeordnet), bewirkt, daß das elektronische Bauelement, insbesondere der Varistor, zwischen diesen beiden Positionierelementen mechanisch stabil angeordnet werden kann, wobei sichergestellt werden kann, daß die beiden Teilelememte keinen elektrischen Kurzschluß bilden. Wenn diese beiden Positionierelemente derart ausgestaltet sind, daß sie eine mechanische Klemmkraft auf das Bauelement bewirken, bewirkt dies, daß die elektrische Verbindung nicht die gesamte mechanische Fixierung zu übernehmen braucht, und daß die elektronischen Bauelemente durch diese mechanische Fixierung gehalten und ausgerichtet werden können, bevor sie dann elektrisch verbunden werden, was wiederum beispielsweise durch Löten geschehen kann. Dies hat den Vorteil einer erleichterten Montage,

Die elektrische Verbindung zwischen Bauelement und unterem Trägerelement und oberem Halteelement kann daher sowohl durch eine kraftschlüssige Verbindung (z.B. Quetschung), als auch durch eine stoffschlüssige Verbindung (Lötung) sichergestellt werden, als auch durch beide.

Wenn ausschließlich das Trägerteilelement der Funktion dient, das elektronische Halbleiterbauelement oder den Varistor zu tragen, so bewirkt dies, daß dieses Trägerelement nur so viele Anschlüsse ausweisen muß, daß die Kippstabilität der Gesamtanordnung sichergestellt ist. Da die Kippstabilität in besonderem Maße bei Dreibeinen sichergestellt ist, ist es besonders bevorzugt, wenn das Trägerelement ein Anschlußbein aufweist und das Halteteilelement zwei Anschlußbeine.

Wenn ausschließlich das Halteteiletement der Funktion dient, das elektronische Halbleiterbauelement oder den Varistor relativ zu dem unteren Trägerelement auszurichten, und/oder dazu dient, die größeren Spannungen bzw. Ströme zu leiten, dann ist es vorteilhaft wenn dieses Haltetcilbauelement mindestens gleich viele, wenn nicht mehr Anschlußbeine aufweist, als das Trägerelement. Besonders vorteilhaft ist, wenn das Trägerelement ein Anschlußbein und das Halteteilbauelemest zwei Anschlußbeine aufweist. Hierdurch kann nicht nur eine optimale Stabilität sichergestellt werden.

Im Fall, daß die größere der am Bauelement anliegenden Spannungen / Ströme über das Halteteilelement geführt wird, wird somit sicher gestellt, daß einerseits die hierdurch bewirkten Störungen vom darunter und direkt auf der Leiterplatte angebrachten Bauelement weggerichtet werden und daß diese höheren Spannungen / Ströme durch die zahlreicheren Anschlüsse schneller und leichter abgeleitet werden, als bei einem Standardbauelement, bei welchem nur jeweils ein Anschlußbein zur Verfügung steht.

Eine weitere vorteilhafte Ausgestaltung der Erfindung, wobei das Positionierelement derart ausgestaltet ist, daß es das auf ihr anordenbare elektronische Bauelement, insbesondere Varistor, oberhalb eines unmittelbar auf der Leiterplatte bereits angeordneten elektronischen Bauelements oder Varistors angeordnet wird, bewirkt, daß mindestens zwei Bauelemente direkt übereinander angeordnet werden können, wobei das erste Bauelement direkt auf der elektronischen Leiterplatte angeordnet ist und das mindestens zweite Bauelement / Varistor erfindungsgemäß mit Hilfe des Positionierelements über dem ersten Bauelement / Varistor.

Je nach Materialwahl der Positionierelemente können diese Positionierelemente hierbei die zusätzliche Wirkung übernehmen, das unter ihnen befindliche Bauelement auch zu kühlen. Dies kann insbesondere dadurch bewirkt werden, indem das Positionierelement das erste Bauelement ebenfalls berührt und mit Hilfe seines Materials die im ersten Bauelement hervorgerufene Abwärme aufnehmen und diese über die Fläche des Positionierelements an die Umgebung abgibt. Dies ist von besonderem Vorteil, wenn die Oberfläche des Positionierelements größer ist, als die des unter ihm befindlichen ersten Bauelements. Dies ist insbesondere der Fall, wenn das Trägerelement als Kühlkörper für das darunter befindliches Bauelement ausgestaltet ist.

Eine Vorrichtung nach einem der zuvor genannten Ansprüche, wobei die Bauteilhöhe des erfindungsgemäßen Positionierelements mit darin enthaltenem Varistor für Spitzenströme bis zu 5000Ampere bei 220 Volt, 2 Millimeter und weniger beträgt, bewirkt eine insgesamt minimierte Bauhöhe zum Verbauen. Hierbei bleibt der Einfluß der Anschlußbeine außer Betrachtung, da diese abhängig von der zu überbauenden Höhe individuell gestaltbar sind.
Gängige vergleichbare Varistoren weisen eine für die Verbauung zu freizuhaltende Länge von 10 Millimetern und eine Breite von 5 Millimetern auf. Das erfindungsgemäße Bauelement hingegen lediglich eine Bauhöhe von 2 Millimetern und darunter und einen Durchmesser von 5 Millimetern. Hierdurch konnte das benötigte Bauvolumen signifikant verringert werden.

Eine weitere vorteilhafte Ausgestaltung der Erfindung, wobei das Positionierelement geeignet ist, ein zweipoliges Bauelement aufzunehmen bewirkt, eben weil die gängigsten Bauelemente zweipolig sind, daß ein derart ausgestaltetes Positionierelement universell bestückbar ist, also mit Kondensatoren ebenso wie mit Widerständen, oder Varistoren etc. bestückbar ist

Ein sich hieraus ergebender Vorteil bei einem Varistor ist, daß ein Varistor üblicherweise zwei große Flächen aufweisen muß, die in einem gewissen Abstand voneinander angeordnet sein müssen. Diese Anschlußfläche wiederum hat einen Einfluss auf den Widerstand des Materials an welchen dieser angeschlossen wird, Je größer die Anschlußfläche des Varistors, desto geringer ist deren Widerstand und desto besser ist sein EMV-Verhalten und seine Ansteuerbarkeit. Durch eine möglichst große Fläche kann daher auch entsprechend schnell möglichst viel Energie aufgenommen werden. Zugleich kann dann eine vergrößerte Fläche auch als Kühlfläche genutzt werden.

Diese Ausgestaltung ist von besonderem Vorteil für Varistoren ohne Lackmantel, weil im erfindungsgeinäßen Fall auf einen Lackmantel verzichtet werden kann. Hierdurch grenzt sie sich insbesondere von gängigen Varistoren, sowie von SMD-Varistoren ab. Erfindungsgemäß kann die gesamte Baugruppe, inklusive des positionierten Varistors dann vergossen werden. Eine weitere vorteilhafte Ausgestaltung der Erfindung, wobei das Positionierelement im vollen Material Aussparungen aufweist hat den Vorteil, daß Gewicht eingespart werden kann und daß die bei Verlöten von Positionierelement und Varistormetallisierung entstehenden Ausgasungen entweichen können. Bevorzugt für derartige Aussparungen sind Löcher von 2-3 mm Durchmesser. Vorzugsweise weisen das obere Haltelement, und/oder das untereTragelement derartige Aussparungen auf um sich mit der metallisierten Varistoroberfläche z.B. verlöten zu lassen. Auf diese Weise ist sichergestellt, daß sowohl das obere Haltelement, als auch das untere Tragelement die Ausgasungen von Inhaltsstoffen des Lötzinns zwischen Blech und Varistor heraus kommen können.

Eine weitere vorteilhafte Ausgestaltung der Erfindung, wobei das Positionierelement mehrstöckig ausgestaltet ist und in jedem Stockwerk Bauelement anordenbar ist, hat den Vorteil einer vielgestöckigen Ausgestaltung der Erfindung, wodurch in besonderem Umfang Platz eingespart werden kann.

Die Aufgabe wird darüber hinaus gelöst durch eine Hybridschaltung, umfassend eine der aufgeführten Ausfuhrungsformen. Bei der Hybridtechnik handelt es sich um eine Aufbau- und Verbindungstechnik zur Herstellung elektronischer Schaltungen (Dickschicht-Hybridschaltung), bei welcher sowohl integrierte als auch diskrete Bauteile Verwendung finden. Derartige Hybridschaltungen weisen folgende Vorteile auf;
➢ Einsatz von Bauteilen verschiedener Fertigungstechniken möglich
➢ Substrat ist ein guter, verlustarmer Isolator
➢ Verlustleistung wird gut über das Substrat abgeführt (annähernd gleiche Temperatur
➢ über die ganze Schaltung hinweg)
➢ drucktechnisch realisierbare Widerstände höchster Genauigkeit (Laserabgleich, besser als 0,1 %) in weiten Wertebereichen (Milli- bis Megaohm).

Die Aufgabe wird darüber hinaus gelöst durch Hausgeräte, umfassend eine der aufgeführten Ausführungsformen. Dies ist insbesondere der Fall bei weißer und brauner Ware.

Insbesondere ist es vorteilhaft, die beschriebene Vorrichtung zur Anordnung elektronischer Bauelemente auf elektronischen Leiterplatten in Waschmaschinen, Spülmaschinen, Dunstabzüge, HiFi-Anlagen, TV-Geräte, Türöffner, Rolladensteuerungen, Wechsel Sprecheinrichtungen, Koch- und Warmhaltevornchtungen, Küchengeräte, Sicherheitseinrichtungen, die Wohntemperatur beeinflussende Steuerungen, Fernbedienungen einzubauen.

Die vorliegende Vorrichtung zur Anordnung elektronischer Bauelemente auf Leiterplatten, weist darüber hinaus Vorteile im Falle einer Maschinenbestückung von Leiterplatten auf.

In diesem Fall kann erfindungsgemäß zunächst das erste Bauelement unmittelbar auf der Leiterplatte aufgebracht werden. In einem weiteren Schritt kann entweder die gesamte erfindungsgemäße Vorrichtung, umfassend auch das im Positionierelement angeordnete Bauelement / Varistor über dem ersten bereits auf der Leiterplatte angebrachten ersten Bauelement angeordnet werden und mit Hilfe der Positionierelemente, also dem unteren Tragelement und dem oberen Halteelement elektrisch leitend verbunden werden. Alternativ kann aber auch in einem weiteren Schritt zunächst das untere Tragelement auf der Leiterplatte angeordnet werden und dann in einem noch weiteren Schritt das Bauelement auf diesem unteren Tragelement, Dann kann das obere Halteelement auf dem Bauelement angebracht werden. Vorzugsweise wird die elektrische Verbindung dieser Elemente auch in dieser Reihenfolge durchgeführt, indem zunächst das erste Bauelement auf der Leiterplatte selbst angeordnet wird, dann wird das untere Tragelement über diesem ersten Bauelement angeordnet und mit der Leiterplatte elektrisch verbunden und dann wird das Bauelement auf diesem unteren Tragelement aufgebracht und mit wiederum diesem elektrisch verbunden und dann wird das obere Halteelement auf diesem Bauelement, insbesondere einem Varistor, aufgebracht und mit dem Varistor und mit der Leiterplatte elektrisch verbunden.

Nachdem auch das erste Bauelement elektrisch mit der Leiterplatte verbunden ist, kann der gesamte Komplex, bestehend aus mindestens unterem Tragelement, Bauelement, oberem Halteelement mit einem Lackmantel versehen werden. Alternativ kann auch das untere Bauelement noch von diesem Lackmantel mit eingeschlossen werden.

Die Aufgabe daher weiterhin gelöst durch Vorrichtung zur Anordnung elektronischer Halbleiterbauelemente auf elektronischen Leiterplatten, umfassend eine elektronische Leiterplatte, ein elektronisches Halbleiterbauelement oder einen Varistor, Positionierelemente, welche das elektronische Halbleiterbauelement oder den Varistor im Wesentlichen parallel zur elektronischen Leiterplatte und von dieser beabstandet anordnen und mit dieser elektrisch verbinden, wobei in einem ersten Schritt die elektronische Leiterplatte mit ihren Bauelementen bestückt wird und in einem zweiten Schritt über mindestens einem der elektronischen Bauelemente der ersten Leiterplatte eine Vorrichtung zur Anordnung elektronischer Halbleiterbauelemente, umfassend ein Halbleiterbauelement und/oder einen Varistor

Weitere Ausgestaltungsformen ergeben sich aus den Fig. Hierbei zeigten:
Fig. 1 eine erfindungsgemäße Vorrichtung zur Anordnung elektronischer Bauelemente auf Leiterplatten in schräger seitlicher Draufsicht und
Fig. 2 sie selbe Vorrichtung in schräger seitlicher Sicht von unten.

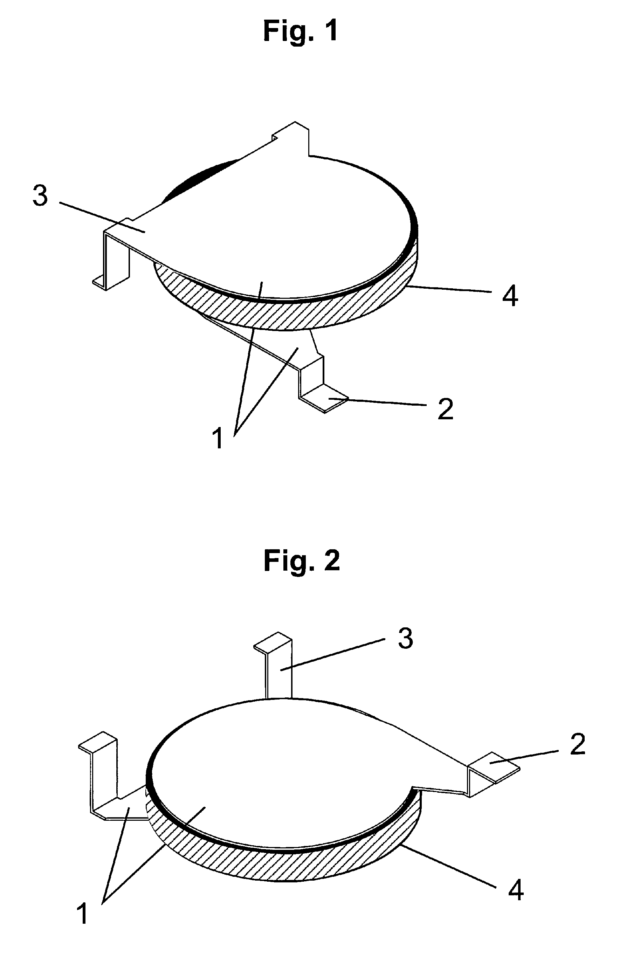

Fig. 1, zeigt insbesondere eine bevorzugte Ausführungsform, umfassend ein Positionierelement 1, welches im vorliegenden Fall aus zwei Teilelementen 2, 3 besteht, nämlich einem Trägerteilelement 2, welches unter dem zu befestigenden Bauelement 4 angeordnet ist, und einem Halteteilelement 3, welches über dem zu befestigenden Bauelement 4 angeordnet ist. Das zu befestigende Bauelement 4 ist daher in der vorliegenden Ausgestaltungsform zwischen diesen beiden Teilelementen angeordnet.

Das untere Trägerteilelement 2 ist im vorliegenden Fall eben ausgestaltet, wobei alternativ aber auch Gestalten möglich sind, welche das aufzunehmende elektronische Bauelement, insbesondere der Varistor, 4 nicht nur mit Hilfe einer eben ausgestalteten Fläche aufzunehmen in der Lage sind, sondern auch in der Lage sind, eine seitliche Stabilisierung zu bieten (nicht dargestellt). Ein derartig gestaltetes unteres Trägerelement 2 ist somit auch geeignet, einen Teil der Seitenfläche des aufzunehmenden Bauelements 4 mit einzubetten. Eine derartige seitliche Aufnahme kann über den gesamten Umfang bestehen, oder auch nur über einen Teil des Umgangs.

In der vorliegenden Ausführungsform ist die Größe der Fläche des Trägerelements 2 der Berührungsfläche des aufzunehmenden Bauelements 4 angepasst.

Darüber hinaus sind auch Ausführungsformen möglich, bei welchen das untere Trägerelement 2 nicht die gesamte Fläche einer Seite des aufzunehmenden Bauelements 4 aufnimmt (nicht dargestellt). Dies ist beispielsweise der Fall, wenn die Aufnahmefläche des unteren Tragelements kleiner ist, als die korrespondierende Aufnahmefläche des Bauelements 4.

Eine alternative Realisierungsmöglichkeit dieses Falls sind Mulden oder sogar Löcher in der Aufnahmefläche des unteren Trägerelements 2. Derartige Aussparungen können vorgesehen werden, um beispielsweise die Kühlwirkung zu erhöhen, indem ein kühlender Luftstrom mit Hilfe von derartigen Löchern unmittelbar zum zu kühlenden Bauelement 4 geleitet wird. Auf diese Weise wird bewirkt, daß die Kühlluft das Bauelement 4 direkt erreicht und nicht mittelbar über das trennende Trägerelement 2.

Derartige Aussparungen können aber auch vorgesehen werden, um den Lötvorgang zu optimieren, um hierdurch dem Lot Möglichkeiten zu geben, ausgasen zu können,

Der äußere Umfang des unteren Trägerteilelements 2 ist im vorliegenden Fall derart ausgestaltet, daß er im Wesentlichen seines Umfangs deckungsgleich mit dem Umfang des aufzunehmenden Varistors ist. Lediglich an einer Stelle ragt das untere Trägerteilelement über diesen Umfang trapezförmig eben-flächig hinaus, wobei dieser hinausragende Abschnitt an seinem Ende in der der Aufnahmefläche entgegengesetzte Richtung eine erste 90°-Stufe und dann noch weiter beabstandet eine zweite 90°-Stufe ausbilden. Diese bilden hierdurch einen Lötschuh aus und dienen der elektrischen Verbindung mit der Leiterplatte. Alternativ zu einem derartigen Lötschuh ist auch eine mechanische Steckverbindung möglich, die nachträglich elektrisch leitend mit der Leiterplatte verbunden wird.

Das obere Halteelement 3 ist im vorliegenden Fall ebenfalls eben ausgestaltet, wobei auch in diesem Fall Gestalten möglich sind, welche das aufzunehmende elektronische Bauelement, insbesondere der Varistor, 4 nicht nur mit Hilfe einer eben ausgestalteten Fläche aufzunehmen in der Lage sind, sondern auch in der Lage sind, eine seitliche Stabilisierung zu bieten (nicht dargestellt). Ein derartig gestaltetes oberes Halteelement 3 ist somit auch geeignet, einen Teil der Seitenfläche des aufzunehmenden Bauelements 4 mit einzubetten. Eine derartige seitliche Aufnahme kann über den gesamten Umfang bestehen, oder auch nur über einen Teil des Umfangs.

In der in Fig. 1, 2 dargestellten Ausführungsform ist analog dem anderen Trägerelement 2 auch die Größe der Fläche des oberen Halteelements 3 der Berührungsfläche des aufzunehmenden Bauteils 4 angepasst, sodaß deren Außenkanten im Wesentlichen deckungsgleich sind.

Darüber hinaus sind auch Ausführungsformen möglich, bei welchen das obere Halteelement 3 nicht die gesamte Fläche einer Seite des aufzunehmenden Bauelements 4 aufnimmt (nicht dargestellt). Dies ist beispielsweise der Fall, wenn die Aufnahmefläche des oberen Halteelements 3 kleiner ist, als die korrespondierende Aufnahmefläche des Bauelements 4 selbst. Eine Realisierungsmöglichkeit sind auch hierfür Mulden oder sogar Löcher in der Aufnahmeflache des oberen Halteelements 3. Derartige Aussparungen können auch beim oberen Halteelement vorgesehen werden, um beispielsweise beim Lötvorgang eine Ausgasung des Lots zu unterstützen bzw. um die Kühlwirkung zu erhöhen, indem beispielsweise ein kühlender Luftstrom mit Hilfe von derartigen Löchern unmittelbar zum zu kühlenden Bauelement 4 geleitet wird. Auf diese Weise wird bewirkt, daß die Kühlluft das Bauelement 4 direkt erreicht und nicht mittelbar über das trennende Halteelement 3.

Der äußere Umfang des oberen Halteelements 3 ist im vorliegenden Fall derart ausgestaltet, daß auch er im Wesentlichen seines Umfangs deckungsgleich mit dem Umfang des aufzunehmenden Varistors ist. Lediglich an zwei voneinander beanstandeten Stellen ragt das obere Halteelement 3 über diesen Umfang trapezförmig eben-flächig hinaus, wobei diese hinausragenden Abschnitte an ihrem Ende von der Aufnahmefläche weg eine erste 90°-Stufe und dann noch weiter beabstandet eine zweite 90°-Stufe ausbilden.

Die Anzahl derartiger über den Umfang hinausragender Abschnitte ist im Grunde beliebig. Vorliegend wurden gemäß Fig. 1; 2 insgesamt drei dieser Abschnitte gewählt, da hierdurch nicht nur die zwei Anschlüsse des Varistors abgedeckt werden können, sondern auch die Bestückbarkeit der Leiterplatte erleichtert wird, da ein derartiges Dreibein kippsicher ist und somit nach der Bestückung bis zur Verlötung nicht kippen kann. Natürlich sind auch mehr als drei derartige Anschlüsse realisierbar.

Diese zwei 90°-Stufen des oberen Halteelements und die eine 90°-Stufe des unteren Halteelements sind derart ausgebildet, daß sie im Fall, daß das Bauelement 4 zwischen oberem Halteelement 3 und unterem Tragelement 2 angeordnet ist, sicherstellen, daß das Bauelement im Wesentlichen parallel zur Leiterplatte ausgerichtet ist. Hierdurch wird die geringsmögliche Bauhöhe sichergestellt. Im Fall daß eine möglichst schmale Anordnung gewünscht ist, ist auch eine vertikale Anordnung auf der Leiterplatte denkbar.

In Fig. 1 und 2 stellen das obere Halteelement 3 und das untere Tragelement 2 zugleich die elektrischen Anschlüsse des Bauelements 4 dar. Das Bauelement 4 ist mit seinem ersten Pol am oberen Halteelement 3 stoffschlüssig befestigt und ist mit seinem zweiten Pol am unteren Tragelement 2 stoffschlüssig befestigt. Hierdurch bilden das obere Halteelement 3 und das untere Tragelement 2 die elektrischen Anschlußpole des Bauelements 4 aus und werden an der vorgesehenen Stelle elektrisch leitend mit der Leiterplatte verbunden.

In der in Fig. 1 und Fig. 2 dargestellten Ausführungsform kann daher beim Bauteil 4 auf eigene Anschlußbeine des Bauelements verzichtet werden, da diese Funktion durch die Gestaltung des unteren Tragelements 2 und des oberen Halteelements 3 mit übernommen wird. Darüber hinaus kann auch auf einen Lackmantel verzichtet werden. Alternativ kann der Lackmantel auch nach Anbringen des Bauelements 4 zwischen dem unteren Tragelement 2 und dem oberen Halteelement 3 aufgebracht werden, wodurch nur noch die Anschlußbeine aus diesem Lackmantel herausragen, oder auch nach deren Montage auf der Leiterplatte wodurch nur auch die Anschlußbeine in dem Lackmantel eingeschossen werden können. Die vorliegende Vorrichtung zur Anordnung elektronischer Bauelemente 4 auf Leiterplatten, welche einen Varistor zwischen einem unteren Tragelement 2 und einem oberen Halteelement 3 anordnet ist mit diesen etwa 15 mm breit, x 18 lang und 5mm hoch.

## Patentansprüche

1. Vorrichtung zur Anordnung elektronischer Halbleiterauelemente (4) auf elektronischen Leiterplatten, umfassend eine elektronische Leiterplatte, ein elektronisches Halbleiterbauelement oder einen Varistor (4), Positionierelemente (1), welche das elektronische Halbleiterbauelement oder den Varistor (4) im Wesentlichen parallel zur elektronischen Leiterplatte und von dieser beabstandet anordnen und mit dieser elektrisch verbinden.

2. Vorrichtung nach Anspruch 1, wobei eines der Positionierelemente mindestens die äußere Kontur einer der der Kontaktflächen des Halbleiterbauelements oder des Varistors im Wesentlichen nachvollzieht oder wobei mehr als eines der Positionierelemente mindestens die äußere Kontur von mehr als einer der Kontaktflächen des Halbleiterbauelements oder des Varistors im Wesentlichen nachvollzieht.

3. Vorrichtung nach einem der zuvor genannten Ansprüche, wobei das elektronische Halbleiterbauelement oder der Varistor (4) ausschließlich mit dem Positionierelement (1) verbunden wird und das Positionierelement (1) mit Hilfe von mehr als zwei Verbindungen ausschließlich mit der Leiterplatte verbunden wird.

4. Vorrichtung nach Anspruch 3, wobei der Stromtransport vom Halbleiterbauelement oder vom Varistor zur Leiterplatte ausschließlich über elektrische Leitelemente des Positionierelements bewirkt wird, und wobei die Verbindung des Positionierelments mit der Leiterplatte mit Hilfe einer am Positionierelement befindlichen leiterplattenparallelen Abschnitts erfolgt.

5. Vorrichtung nach einem der zuvor genannten Ansprüche, wobei das Positionierelement (1) aus mindestens zwei Teilelementen (2, 3) besteht, nämlich mindestens einem Trägerteilelement (2) umfasst und mindestens ein Halteelelement (3).

6. Vorrichtung nach Anspruch 5, wobei ausschließlich das Trägerteilelement (2) der Funktion dient, das elektronische Halbleiterbauelement oder den Varistor (4) zu tragen.

7. Vorrichtung nach Anspruch 5 oder 6, wobei ausschließlich das Halteteilelement (3) der Funktion dient, das elektronische Halbleiterbauelement oder den Varistor (4) relativ zu dem unteren Trägerelement (2) auszurichten und/oder dazu dient, die größeren Spannungen bzw. Ströme als das Trägerteilelement zu leiten.

8. Vorrichtung nach einem der zuvor genannten Ansprüche, wobei das Positionierelement (1) derart ausgestaltet ist, daß es das auf ihr anordenbare elektronischehalbleiterbauelement oder den Varistor (4) oberhalb eines unmittelbar auf der Leiterplatte bereits angeordneten elektronischen Halbleiterbauelements oder eines Varistors anordnet.

9. Vorrichtung nach Anspruch 8, wobei das Trägerelement (2) als Kühlkörper für das darunter befindliche Bauelement ausgestaltet ist.

10. Vorrichtung nach einem der zuvor genannten Ansprüche, wobei die Bauteilhöhe des erfindungsgemäßen Positionieretements mit dann enthaltenen Varistor für Spitzuenströme bis zu 5000Ampere bei 220 Volt 2 Millimeter und weniger beträgt.

11. Vorrichtung nach einem der zuvor genannten Ansprüche, wobei der Varistor ein Varistor ohne Lackmantel ist.

12. Vorrichtung nach einem der zuvor genannten Ansprüche, wobei das Positionierelement (1) im vollen Material Aussparungen aufweist.

13. Vorrichtung nach einem der zuvor genannten Ansprüche, wobei das Positionierelement (1) mehrstöckig ausgestaltet ist und in jedem Stockwerk ein Halbleiterbauelement (4) anordenbar ist.

14. Hybridschaltung umfassend eine Vorrichtung nach einer der zuvor genannten Ansprüche.

15. Hausgerät und/oder Stromnetz, umfassend eine Vorrichtung nach einer der zuvor genannten Ansprüche.
